Europäisches Patentamt

(19) European Patent Office

Office européen des brevets

(11) Publication number: **0 091 686**
**B1**

(12) **EUROPEAN PATENT SPECIFICATION**

(45) Date of publication of patent specification: **28.06.89**

(21) Application number: **83103501.9**

(22) Date of filing: **11.04.83**

(51) Int. Cl.⁴: **H 01 L 21/38, H 01 L 29/08,**
**H 01 L 29/78**

(54) Semiconductor device having a diffused region of reduced length and method of fabricating the same.

(30) Priority: **12.04.82 US 367316**

(43) Date of publication of application:
**19.10.83 Bulletin 83/42**

(45) Publication of the grant of the patent:
**28.06.89 Bulletin 89/26**

(84) Designated Contracting States:
**CH DE FR GB LI NL SE**

(56) References cited:
**FR-A-2 487 583**
**GB-A-2 088 631**
**US-A-3 975 221**

**IBM TECHNICAL DISCLOSURE BULLETIN, vol.
22, no. 8B, January 1980, pages 3705,3706,
New York, US; R.C.VARSHNEY: "Self-Aligned
VMOS structure using reactive ion etching"**

**IEEE TRANSACTIONS ON ELECTRON
DEVICES, vol. ED-25, no. 10, October 1978,
pages 1185-1193, IEEE, New York, US;
K.E.BEAN: "Anisotropic etching of silicon"**

(73) Proprietor: **GENERAL ELECTRIC COMPANY**
**1 River Road**
**Schenectady New York 12305 (US)**

(72) Inventor: **Baliga, Bantval Jayant**
**3 Clove Court Clifton Park**
**New York 12065 (US)**
Inventor: **Gray, Peter Vance**
**121 Acorn Drive**
**Scotia New York 12302 (US)**
Inventor: **Love, Robert Paul**
**49 Hillcrest Avenue**
**Schenectady New York 12304 (US)**

(74) Representative: **Kinne, Reinhard, Dipl.-Ing. et al**
**Patentanwaltsbüro Tiedtke-Bühling-Kinne-
Grupe-Pellmann-Grams-Struif Bavariaring 4
D-8000 München 2 (DE)**

## Description

The present invention is concerning a semiconductor device according to the classifying portion of claim 11 and a method of fabricating a semiconductor device of that kind according to the classifying portion of claim 1.

A method of fabricating a semiconductor device of that kind is known from the document IBM Technical Disclosure Bulletin, Vol. 22, No. 8B, January 1980, pages 3705—3706, New York, USA, R. C. Varshney: "Self-aligned VMOS-structure using reactive ion etching", which document discloses the fabrication of a V-groove in self-alignment with a diffusion region in a semiconductor device.

In some types of semiconductor devices—such as MOSFETs or IGRs (insulated gate rectifiers)—fabricated by that known method there exists the problem of a turn-on or incipience of current conduction in a parasitic bipolar transistor inherent in said semiconductors. Turn-on of such parasitic transistor is inevitably accompanied by a partial or total loss of control of current in the semiconductor device, and may even result in complete destruction of the device.

To help prevent turn-on of an included parasitic bipolar transistor, a typical prior art device, for instance, a MOSFET, incorporates a "electrical short", or low resistance connection, between the adjoining SOURCE and BASE regions, which have a P—N junction between them. The purpose is to prevent such P—N junction from becoming forward biased above a threshold level that would induce turn-of of the parasitic transistor. To insure that no part of the P—N junction becomes excessively forward biased, the distance between the short and the furthest part of the P—N junction, which corresponds generally to the length of the SOURCE, should be minimized. The SOURCE, however, has a minimum length typically in excess of about 10 micrometers, as a result of the mentioned prior art method of fabricating the MOSFET.

A prior MOSFET is made by diffusing into its BASE a suitable type dopant, through a diffusion window, to form its SOURCE. Thereafter, an etchant is applied to the SOURCE through an etch window, to etch through an intermediate portion of the SOURCE. This requires aligning the etch window over the SOURCE, this alignment being a delicate procedure because the SOURCE is so small. Consequently, the SOURCE must be long enough to accommodate an alignment tolerance. It would thus be desirable to provide a semiconductor device having a diffused region (i.e., the SOURCE in a MOSFET) of reduced length.

It is the object of the present invention to provide a method of fabricating a semiconductor device according to the classifying portion of claim 1, which allows to produce a semiconductor device according to the classifying portion of claim 11 having a diffused region of reduced length forming the SOURCE, said method not requiring a delicate alignment step for forming the SOURCE.

According to the invention this object is achieved by the advantageous measures as indicated in the characterizing portion of claim 1.

Hence, according to the present invention, an anisotropic etchant is applied which etches only in a limited direction, to the N⁺ SOURCE through the same diffusion window. This etchant etches away most of the N⁺ SOURCE; however, the etchant allows shoulders of the SOURCE to remain intact. These shoulders, which form the completed N⁺ SOURCE regions, are of dramatically reduced length; typically, they are each 1 micrometer long. No delicate alignment step to form the N⁺ SOURCE is required.

While the specification concludes with claims particularly pointimg out and distinctly claiming the subject matter which we regard as our invention, it is believed that the invention will be better understood from the following description, taken in connection with the drawings, in which:

Figure 1A is a schematic view in cross-section of a prior art MOSFET;

Figure 1B and 1C are views similar to Figure 1A, illustrating selective prior art steps of fabricating the MOSFET of Figure 1A;

Figures 2A—2G are schematic views in cross-section of selected steps of fabricating a MOSFET in accordance with the present invention;

Figure 3 is a view similar to Figure 2G, illustrating an alternative semiconductor device in accordance with the present invention;

Figures 4A—4G are views similar to Figures 2A—2G, illustrating a second embodiment of a method of fabricating a MOSFET in accordance with the present invention; and

Figure 5 is a view similar to Figure 4G, illustrating an alternative semiconductor device in accordance with the present invention.

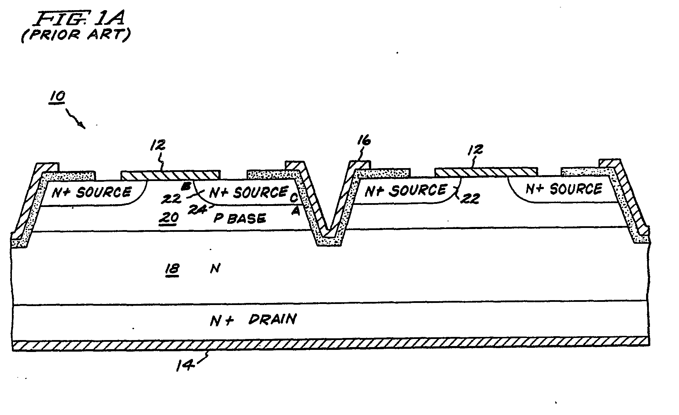

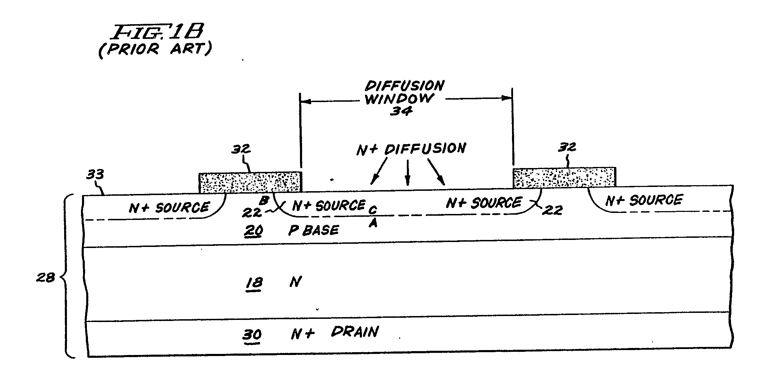

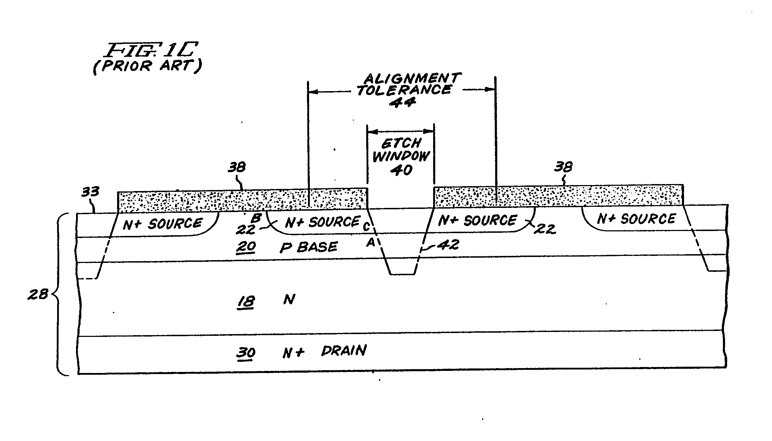

The invention can be more fully understood by first considering the prior art in connection with Figures 1A—1C.

Figure 1 illustrates a prior art MOSFET 10 having many identity "cells", or repeated units of structure. For simplicity, explicit reference is made only to the centrally depicted cell of the MOSFET 10.

The MOSFET 10 is typically used to control the current level in an external circuit (not shown), which is connected between its SOURCE and drain electrodes 12 and 14. In particular, the "gate" or control electrode 16 normally determines such current level, depending upon the amplitude of a control voltage impressed on it. Normal operation of the MOSFET 10 is subject, however, to the adverse effect of turn-on of its inherent parasitic N—P—N transistor, formed from N region 18, P BASE 20, and N⁺ SOURCE 22. If the parasitic transistor turns-on, the MOSFET 10 begins to lose control of the external circuit current level. The parasitic transistor become so conductive that all control of the external circuit current level is lost, and the MOSFET 10 itself can be destroyed.

The parasitic transistor will turn-on if any portion of the P—N junction 24 between P BASE 20 and N⁺ SOURCE 22 (e.g., between locations A and C) becomes forward biased by more than about 0.7

volts (for a silicon device). To reduce this effect, an electrical short between P BASE 20 and $N^+$ SOURCE 22 is implemented at location $B$ by source electrode 12. As a result, the voltage drop across the P—N junction 24 at location $B$ is held to 0 volts. This condition, however, does not hold for portions of the P—N junction 24 remote from location $B$. Indeed, the voltage drop between locations $A$ and $C$ can rise above 0.7 volts if sufficient hole current flows between locations $A$ and $B$ in P BASE 20, resulting in a voltage drop from location $A$ to $B$. In MOSFET 10, there are two mechanisms which can cause this type of hole current. One is known as "leakage" current, which occurs when the MOSFET 10 is in a "blocking state, in which it does not conduct external device current; the other occurs when the MOSFET 10 is in the process of changing from its conducting state to its blocking state, and an excess of holes in P BASE 20 are caused to flow to the source electrode near location $B$.

The longer the distance $A$—$B$ along P—N junction 24, the higher the voltage drop between locations $A$ and $B$, and the more likely P—N junction 24 will become forward biased above 0.7 volts, with attendant turn-on of the parasitic transistor. Therefore, it would be desirable to reduce the distance $A$—$B$, for example, by reducing the length of $N^+$ SOURCE 22; that is, its horizontal dimension in Figure 1A. The mentioned prior art technique of fabricating electrical shorts in the MOSFET 10, such as at location $B$, however, results in a length $N^+$ SOURCE 22. This is because the technique includes a delicate alignment step, and the $N^+$ SOURCE 22 must be long in order to accommodate the unavoidable alignment tolerance. These particulars, as well as further drawbacks of the prior art technique, can be more easily appreciated by referring to Figures 1B and 1C.

Figure 1B shows a semiconductor body 28 including $N^+$ DRAIN 30, N region 18, and P BASE 20. A diffusion barrier or mask 32, such as silicon dioxide, is provided on the upper surface 33 of the body 28. The diffusion mask 32 defines diffusion window 34 (and adjacent diffusion windows). An $N^+$ diffusion of dopant through the upper surface 33 is performed and forms the $N^+$ SOURCE 22 (shown in phantom).

As shown in Figure 1C, an etch barrier or mask 38, such as silicon dioxide, is next provided on the upper surface 33. The etch mask 38 defines an etch window 40. An etchant is applied through the etch window 40 to remove semiconductor material from the body 28 to form groove 42 (shown in phantom), necessary for implementing the completed MOSFET 10 (Fig. 1). Proper construction of the $N^+$ SOURCE 22 requires that the etch window 40 be aligned as closely as is feasible to the center of the $N^+$ SOURCE 22. However, this alignment step is extremely delicate, since the dimensions involved are exceedingly minute (e.g., on the order of 5 micrometers).

Because the foregoing alignment step is delicate, precise alignment is not consistently attainable. Consequently, the etch window 40 falls at random within a minimum alignment tolerance 44. In order to accommodate the alignment tolerance 44, the completed $N^+$ SOURCE 22 must be lengthy. This, however, increases the risk of the parasitic transistor turning on. A further drawback of having the $N^+$ SOURCE 22 lengthy is that the individual size of each cell in the MOSFET 10 is increased. This undesirably limits the amount of current that the MOSFET 10 can carry, and reduces the manufacturing yield of operable MOSFETs. Additionally, the inclusion of the foregoing delicate alignment step further reduces the manufacturing yield of operable MOSFETs.

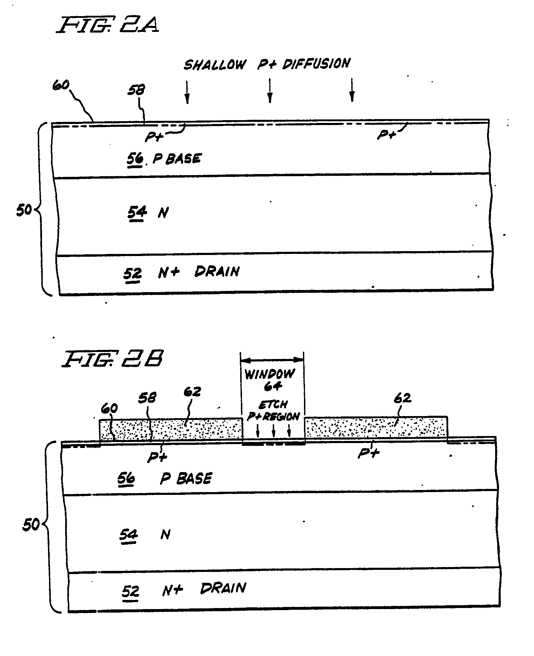

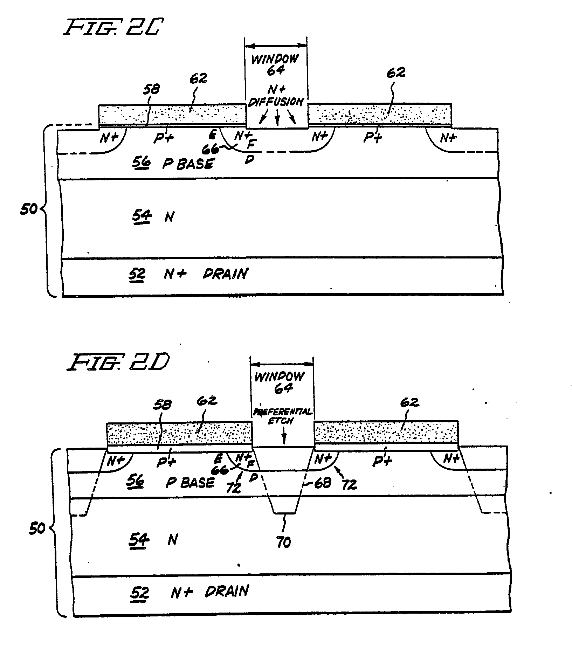

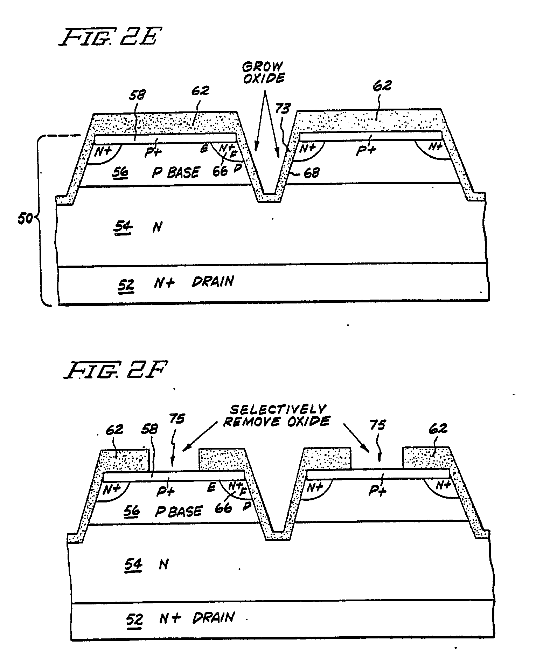

The details of the present invention will now be described in connection with the embodiment of Figures 2A—2G inclusive, illustrating a preferred method of fabricating a MOSFET.

As shown in Figure 2A, there is provided a semiconductor body 50, typically of silicon, which is suitably identical to the prior art body 28 shown in Figure 1B. In particular, $N^+$ DRAIN 52 typically comprises a substrate layer, with N-type layer 54 epitaxially grown on $N^+$ DRAIN 52, and P BASE 56 epitaxially grown on (or diffused into) the N-type layer 54. This construction is typical of "power" MOSFET, or MOSFETs designed to carry substantial levels of current. The present invention, however, can be practised with non-power devices, too.

Figure 2A additionally illustrates a processing step for implementing $P^+$ region 58 (shown in phantom). There is diffused a very shallow (i.e., a fraction of a micrometer) layer of P-type dopant, such as boron, at a high dopant concentration, into the upper surface 60 of the wafer 50. This step is known in the art as predeposition.

Subsequently, there is provided a thick layer (e.g., 2 micrometers) of silicon dioxide, or other suitable diffusion resistant material, to the body upper surface 60, which is patterned by using photolithography (a known technique) to provide a mask 62, as shown in Figure 2B, which defines a window 64.

As shown in phantom in Figure 2B, then the $P^+$ region 58 in the window 64 of the centrally depicted cell, or repeated unit of structure in the body 50, and simultaneously the $P^+$ region 58 in adjacent cells are etched away. (For simplicity, the description below is explicit only as to the central cell). This etching need not be anisotropic, or directional. A suitable etching technique, for example, is planar plasma etching.

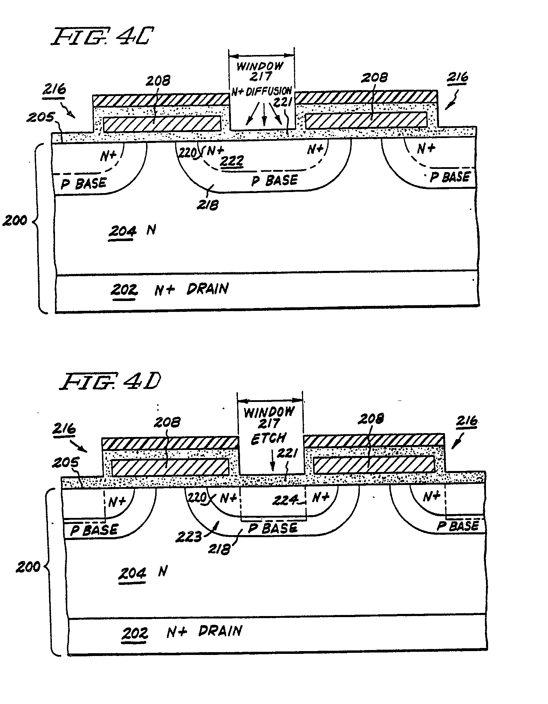

Next, as illustrated in Figure 2C, an N-type dopant, such as phosphorus, is diffused through the window 64 to form $N^+$ SOURCE 66 (shown in phantom). During this diffusion step, the shallow $P^+$ region 58 is "driven", or thermally diffused deeper, into the body 50 (as is apparent in Figure 2D).

After the $N^+$ SOURCE 66 is implemented, the mask 62 serves additionally as an etch barrier or mask, as shown in Figure 2D. Through the same window 64, defined by the mask 62, there is applied an etchant to etch into the semiconductor body 50. In the preferred embodiment, the etchant is dependent upon the crystal orientation of the silicon body 50, such orientation being (100). An orientation-dependent etchant, a specific type of anisotropic etchant, etches in different directions in the body 50 at different rates, and, as shown in Figure 2D, etches completely through the N$^+$ SOURCE 66 and produces a V-shaped groove 68 (shown in phantom), with or without a flat bottom 70. Such etchant does not undercut beneath the mask 62 and hence does not completely etch away the N$^+$ SOURCE 66. This allows portions of N$^+$ SOURCE 66 beneath the mask 62, or "shoulders" 72, to remain intact.

As shown in Figure 2E, subsequently an insulating layer 73 is provided to cover the surface of the groove 68. A preferred way of implementing the layer 73 is to grow it as an oxide of the semiconductor body 50. This is accomplished by exposing the body 50 to oxygen at high temperature.

Next, as shown in Figure 2F, portions of the insulating layer 62 are selectively removed to provide openings 75. This is accomplished by photolithography.

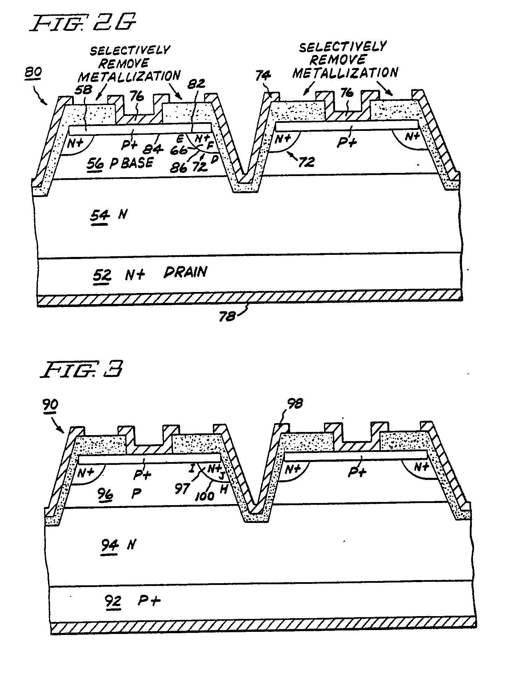

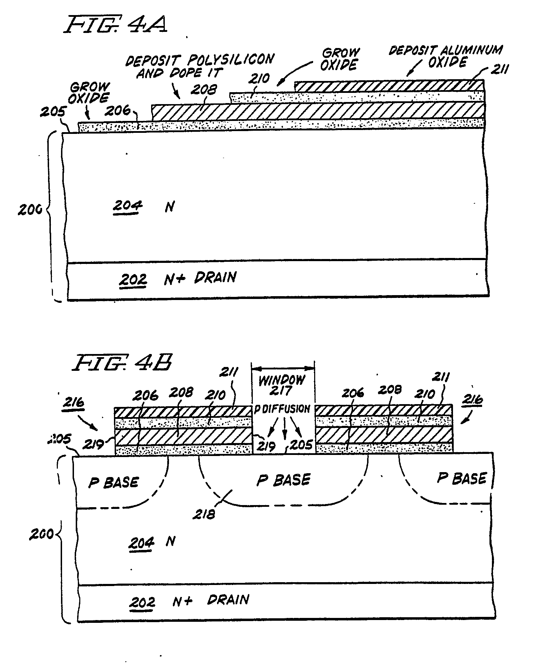

When metallization is applied over the entire upper surface of the structure of Figure 2F, and portions of such metallization are selectively removed, as shown in Figure 2G. The remaining metallization 74 forms a gate electrode, and the remaining metallization 76 forms a source electrode in contact with the P$^+$ region 58. Lastly there is applied metallization 78 to the lower surface of the N$^+$ DRAIN 52 to form a drain electrode and implement the MOSFET 80.

In the MOSFET 80, the P$^+$ region 58 advantageously completes an electrical short between P BASE 56 and N$^+$ SOURCE 66, e.g., at location $E$. This electrical short has three components. One component comprises the junction 82 between the P$^+$ region 58 and the N$^+$ SOURCE 66, which junction forms a "tunnel" junction, because each of the foregoing regions is heavily doped (i.e., each has a doping concentration in excess of about $10^{19}$ dopant atoms per cm$^3$ of silicon). The tunnel junction 82 constitutes a low resistance connection between the N$^+$ SOURCE 66 and the P$^+$ region 58, at least during normal device operation. Tunnel junctions are discussed more fully, for example, in S. M. Sze, *Physics of Semiconductor Devices*, New York: Wiley-Interscience, 1969, Chapter 4. The second component of the electrical short at location $E$ comprises the junction 84, between P BASE 56 and P$^+$ region 58. The junction 84 constitutes a low resistance path between the P BASE 56 and the P$^+$ region 58, because holes can freely pass from the P BASE 56 to the P$^+$ region 58. The third component of the electrical short at location $E$ comprises the P$^+$ region 58, in the vicinity of location $E$, between the tunnel junction 82 and the junction 84. This is because the region 58 is highly doped, and so constitutes a low resistance path between the junctions 82 and 84. All three of the foregoing low resistance paths collectively provide a low resistance path between the P BASE 56 and the N$^+$ SOURCE 66, thus implementing the electrical short between these regions at location $E$.

The tunnel junction 82 is also part of a low resistance path between the N$^+$ SOURCE 66 and the source electrode 76, such low resistance path also including the highly-doped P$^+$ region 58. Because the P$^+$ region 58 is highly-doped and thus conductive, the source electrode 76 only needs to make contact with it at isolated locations.

The MOSFET 80 possesses significant advantages over the prior art MOSFET 10, described above. First and foremost, the length of the N$^+$ SOURCE 66 is drastically reduced compared to the prior art. This is because all but the shoulders 72 of the N$^+$ SOURCE 66 have been etched away. Accordingly, the electrical short at location $E$ is highly effective. This is because hole current flowing in P BASE 56, from location $D$ to location $E$, produces only a low voltage drop since the distance $D$—$E$ is short. Accordingly, it is unlikely that any portion of P—N junction 86 between P BASE 56 and N$^+$ SOURCE 66 (e.g., between locations $D$ and $F$) can become excessively forward biased. This greatly reduces the likelihood of turn-on of the parasitic bipolar transistor in the MOSFET 80 (i.e., the transistor formed by N-region 54, P BASE 56, and N$^+$ SOURCE 66).

Significantly, MOSFETs made by the present invention allow reduced cell size using present state of the art processing techniques. For a typical MOSFET, this size reduction amounts to about 50 percent. This dramatically increases the manufacturing yield of operable MOSFETs, which makes them less costly. Additionally, the size reduction increases the current-carrying capability of a 500 volt-rated MOSFET by about 30 percent, and of a 50 volt-rated MOSFET by about 100 percent. Accordingly, smaller and less costly MOSFETs made in accordance with the invention are needed in a given application, compared with MOSFETs made by conventional methods.

The foregoing described method of fabricating the MOSFET 80 could be modified, for example, by employing an anisotropic etchant other than the preferred orientation-dependent etchant mentioned above. However, such other suitable etchant must allow shoulders 72 of the N$^+$ SOURCE 66 to remain intact. By way of example, other suitable etchants include a vertically collimated beam of reactive ions and a planar plasma etchant. These etchants tend to form a groove 68 (Figure 2D) having more of a U-shape than a V-shape. These etchants do not require the semiconductor body (100) to be crystal oriented, as does the preferred, orientation-dependent etchant.

A further modification of the foregoing method of fabricating the MOSFET 80 (Figure 2G) is to form the gate electrode 74 from a conductive refractory material, rather than by metallization. Suitable refractory materials include highly-doped polysilicon, molybdenum silicide and tungsten silicide. If polysilicon were used, the foregoing method could be altered as follows, by way of example. After the insulating layer 62 of Figure 2E has been formed, polysilicon (not illustrated) is deposited on the upper surface of the structure shown in Figure 2E. The polysilicon layer is highly doped to make it conductive, and is patterned to remove it from the desired locations for the source electrode. A layer of oxide is grown on the polysilicon by exposing it to oxygen at high temperature, openings similar to openings 75 (Figure 2F) are made, and, finally, metallization is applied to the upper surface of the modified structure to implement the source electrode.

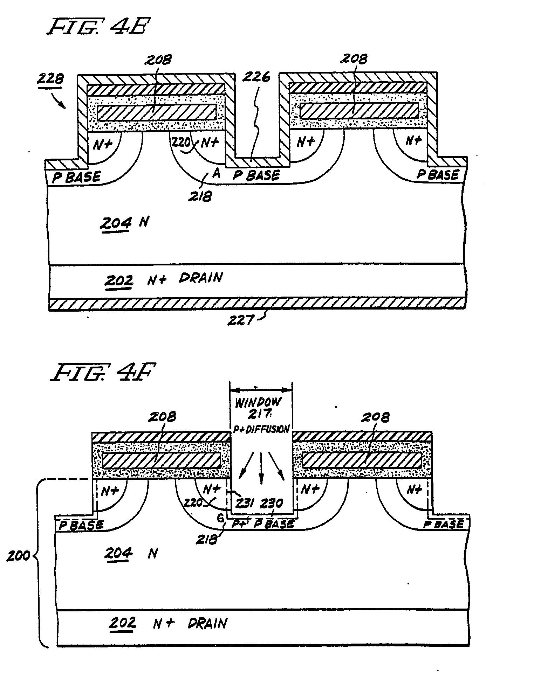

The present invention is applicable to semiconductor devices other than MOSFETs. Another appropriate semiconductor device is an insulated gate rectifier (IGR), shown in Figure 3. The IGR 90 includes a P$^+$ substrate 92, in contrast with the N$^+$ DRAIN substrate 52 of the MOSFET 80. With this substitution, the foregoing method of fabricating the present embodiment of the invention is applicable to the IGR 90.

The present invention attains advantages for the IGR 90, which are similar to the above-mentioned advantages for the MOSFET 80. In particular, the parasitic N—P—N transistor in the IGR 90, formed by N region 94, P region 96, and N$^+$ region 97, is electrically coupled in thyristor fashion to a parasitic P—N—P transistor—namely, the transistor formed by P$^+$ region 92, N region 94, and P region 96. Accordingly, these parasitic transistors can "latch", or become established in a current-conducting state, if the N—P—N (or upper transistor) is allowed to turn on. Once the IGR 90 becomes latched, control of its current level by its gate 98 is totally lost. This risk of the IGR 90 becoming latched is always present when the IGR 90 is in its active or current-carrying state. The invention greatly diminishes this risk by preventing the N—P—N transistor from becoming excessively active. This is because the distance H—I in P region 96 along P—N junction 100 is so short that P—N junction 100 (e.g., between locations H and J) cannot become excessively forward biased. Additionally, the IGR 90 can have a reduced cell size, compared to IGRs made from prior art methods, enabling the IGR 90 to be made more economically and carry more current.

The modifications to the method of fabricating the MOSFET 80, described above, apply equally well to the IGR 90.

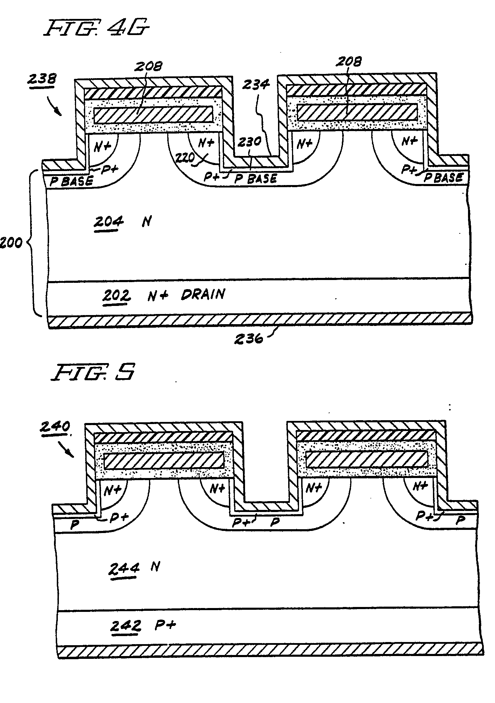

The invention will now be described in connection with the embodiment of Figures 4A—4E, illustrating a preferred method of fabricating a MOSFET. As shown in Figure 4A, there is provided a semiconductor body 200, typically of silicon. The body 200 typically comprises a substrate 202, constituting an N$^+$ DRAIN, and an N region 204, typically epitaxially grown on the N$^+$ DRAIN 202. This construction is typical of power MOSFETs, although the invention can be practised with non-power devices.

On the upper·surface 205 of the body 200, there is formed an insulating layer 206, suitably by growing an oxide on the body 200. Next, there is formed a conductive refractory material 208 (shown partially broken away) on the insulating layer 206. Where, for example, the refractory material comprises polysilicon it is doped highly to make it conductive. Next, insulating layer 210 is formed on the upper surface of the refractory material 208. With the refractory material 208 comprising polysilicon, the insulating layer 210 suitably comprises an oxide grown thereon. Finally, a layer 211 is formed on the insulating layer 210, if provided, or directly on the refractory material 208. The layer 211 rises a material, such as aluminum oxide, which is resistant to an etchant, that etches through silicon dioxide and silicon during a processing step described below, then the layers 206, 208, 210 and 211 are patterned by conventional photolithography to produce mask 216, appearing in Figure 4B. The mask 216 defines a window 217 and serves as a diffusion barrier when next there is made a P-type diffusion through the window 217 to form P BASE 218 (shown in phantom).

As shown in Figure 4C, an N$^+$ diffusion is made through the window 217 to form N$^+$ SOURCE 220 (shown in phantom). The N$^+$ diffusion extends laterally beneath the refractory material 208, i.e., in region 222, approximately the same distance as it diffuses vertically downward. This diffusion occurs at high temperature in an oxidizing atmosphere. As a result, the exposed surfaces 219 (shown in Figure 4B) of the refractory material 208 become oxidized so that the refractory material 208 becomes surrounded by insulating material, as shown in Figure 4C. Similarly, the exposed portions of the semiconductor body surface 205 (shown in Figure 4B) becomes oxidized to form oxide layer 221, (shown in Figure 4C).

As illustrated in Figure 4D, next there is applied an anisotropic etchant (described below) to the oxide layer 221, through the same window 217 which served as the diffusion window for the N$^+$ SOURCE 220. This etchant etches through the oxide layer 221 and at least substantially all the way through N$^+$ SOURCE 220, but allows shoulders 223 of the N$^+$ SOURCE 220 to remain intact. In the preferred embodiment, this etchant suitably comprises a vertically collimated beam of reactive ions or a planar plasma etchant, and forms a generally U-shaped groove 224. Alternatively, a V-shaped groove (not illustrated) could be formed by first using one of the preceding etchants to remove the oxide layer 221, and then using an orientation-dependent etchant (such as a mixture of potassium hydroxide and isopropanol, in the approximate ratio of 3 to 1) to etch into the semiconductor body 200. In this case, the body 200 would need to have a (100) crystal orientation, and an insulating layer 210 (Figure 4A) is necessary, because the layer 211 (at least where it comprises aluminum oxide) is removed by the orientation-dependent etchant (at least where it comprises potassium hydroxide).

Then the MOSFET 228 as shown in Figure 4E is formed by applying metallization 226 and 227 to the upper and lower surfaces, respectively, of the structure of Figure 4D. An electrical short in the MOSFET 228 exists at location *A*, where the metallization 226 electrically connects the P BASE 218 to the N⁺ SOURCE 220.

Prior art for the MOSFET 228 (as described in detail in a discussion by B. J. Baliga, "Silicon Power Field Controlled Devices and Integrated Circuits", in *Silicon Integrated Circuits: Part B*, edited by D. Kahng, New York: Academic Press (1981), pages 209—228) has basically the same drawbacks of the prior art MOSFET 10, shown in Figure 1A and described above. These drawbacks include having a lengthy SOURCE, requiring a delicate alignment step for implementing electrical shorts, and including more processing steps to implement electrical shorts. All of these drawbacks are obviated by the present embodiment of the present invention.

In a preferred modification of the present embodiment, there are formed more reliable electrical shorts by using tunnel junctions. To implement this modification, there is carried out a P⁺ diffusion to form P⁺ region 230, as shown in phantom in Figure 4F, upon completing the etching step shown in Figure 4D. Both the P⁺ region 230 and the N⁺ SOURCE 220 are highly doped so that the junction 231 between them comprises a tunnel junction. An electrical short between P BASE 218 and N⁺ SOURCE 220 exists at location *G*, adjacent tunnel junction 231 (in similar fashion as with the electrical short at location *E* in the MOSFET 80 of Figure 2G). Subsequently, the modified MOSFET 238 as shown in Figure 4G is implemented (by applying metallization 234 and 236 to the upper and lower surfaces, respectively, of the structure of Figure 4F.

The present embodiment of the invention applies to semiconductor devices other than MOSFETs. Another appropriate semiconductor device is an insulated gate rectifier (IGR) 240, as shown in Figure 5. The IGR 240 is similar to the MOSFET 238 (Figure 4G), except that the IGR 240 includes a P⁺ substrate 242, in contrast with the N⁺ DRAIN substrate 202 of the MOSFET 238. With this substitution, the foregoing method of fabricating of the present embodiment of the invention is applicable to the IGR 240.

While the invention has been described with respect to specific embodiments, many modifications and substitutions will be apparent to those skilled in the art. For example, complementary semiconductor deices could be made, in which P-type material is used rather than N-type material, and vice-versa. Further, a "MOSFET" is intended to describe any form of insulated gate field-effect transistor. Additionally, the diffusion steps described herein could include the step of ion implanting—a technique of injecting dopant atoms into a semiconductor body—before the dopant atoms are diffused deeper into the semiconductor body.

## Claims

1. A method of fabricating a semiconductor device, of the type wherein a mask (62; 216), defining a window (64; 217) is applied to a major surface (60; 205) of a semiconductor body (50; 200), and a first region (66; 220) of one dopant type (N⁺) is formed in a second region (56; 218) of opposite dopant type (P) in said body (50; 200) by diffusing a dopant of said one type into said body (50; 200) through said window (64; 217), with said mask (62; 216) serving as a diffusion barrier, characterized by

etching with an anisotropic etchant into said body (50; 200) through said window (64; 217) with said mask (62; 216) serving as an etch barrier; said etching penetrating at least all the way through said first region (66; 220) but allowing shoulders (72; 223) of said first region (66; 220) to remain intact.

2. The method according to claim 1, wherein said anisotropic etchant comprises an etchant which etches in a direction dependent on the crystal orientation of said semiconductor body (50; 200).

3. The method according to claim 1 or 2, further comprising electrically connecting said first (66; 220) and second region (56; 218) to form electrical shorts (58; 230, 234; 226) therebetween.

4. The method according to claim 3, wherein the step of electrically connecting said first and second regions comprises diffusing through said window (217) a third region (230) of opposite dopant type (P) into said semiconductor body (200), said third region (230) adjoining said second region (218) and forming a tunnel junction with said first region (220).

5. The method according to any one of the preceding claims, wherein said semiconductor body (50; 200) comprises a substrate (52; 92; 202; 242) with an epitaxial layer (54, 56; 94, 96; 204; 244) thereon.

6. The method according to claim 5, wherein said substrate (52, 202) comprises the drain of a MOSFET of said one dopant type.

7. The method according to claim 5, wherein said substrate comprises a region (92; 242) of an insulated gate rectifier of said opposite dopant type.

8. The method according to any one of the preceding claims, wherein said mask (216) comprises conductive refractory material (208) and an oxide (206) of said semiconductor body (200), said oxide (206) insulating said refractory material (208) from said body (200).

9. The method according to any one of the preceding claims, wherein said one dopant type comprises N-type.

10. The method according to any one of the preceding claims, wherein said semiconductor body (50; 200) comprises silicon.

11. A semiconductor device having first (66; 97; 220) second (56; 96; 218), third (54; 94; 204; 244) and fourth (52, 92; 202; 242) successively adjoining regions, with said first, second and third regions being of alternate conductivity types and said first region being diffused in said second region; a first electrode (76, 234) electrically connected to said second region (56; 96; 218); a second electrode (78; 236) electrically connected to said fourth region (52; 92; 202, 242); a third electrode (74; 98; 208) overlying but insulated from portions of said first, second and third regions and an etched groove (70; 224) which is in self-alignment with and surrounded by said diffused first region and which is penetrating at least a portion of said second region and insulatively covered by said third electrode; characterized in that said first region (66; 97; 220) has a diffusion depth approximately equal to its lateral extension.

12. Semiconductor device according to claim 11, wherein said first region (66; 97; 220) is electrically connected to said second region (56; 96; 218) such that there is formed an electrical short therebetween.

13. Semiconductor device according to claim 11 or 12, further comprising a fifth region (230) the conductivity type (P) of which is opposite to that of said first region (220); said fifth region (230) adjoining said second region (218) and forming a tunnel junction with said first region (220), thereby implementing an electrical short between said first and second regions.

14. Semiconductor device according to any one of claims 11 to 13, wherein said fourth region (52; 92; 202; 242) comprises a substrate and said third region (54; 94; 204; 244) comprises an epitaxial layer on said substrate.

15. Semiconductor device according to claim 14, wherein said substrate (52; 202) comprises the drain of a MOSFET of same conductivity type (N⁺) as that of said first region (66; 220).

16. Semiconductor device according to claim 14, wherein said substrate (92; 242) comprises a region of an insulated gate rectifier of conductivity type opposite (P⁺) to that of said first region (97).

17. Semiconductor device according to any one of claims 11 to 16, wherein said first region (66; 97; 220) is of N-type conductivity.

18. Semiconductor device according to any one of claims 11 to 17, wherein said first, second, third and fourth regions each comprise silicon.

**Patentansprüche**

1. Verfahren zum Herstellen einer Halbleitervorrichtung der Art, bei der eine Maske (62; 216), die ein Fenster (64; 217) definiert, auf einer Hauptoberfläche (60; 205) eines Halbleiterkörpers (50; 200) aufgebracht wird und bei der ein erster Bereich (66; 220) eines Dotierungstyps (N⁺) in einem zweiten Bereich von gegensätzlichem Dotierungstyp (P) in dem Körper (50; 200) durch Diffundieren eines Dotierungsmittels des einen Typs in den Körper (50; 200) durch das Fenster (64; 217) ausgebildet wird, wobei die Maske (62; 216) als Diffusionsbarriere dient, dadurch gekennzeichnet, daß mit einem anisotropen Ätzmittel durch das Fenster (64; 217) in den Körper (50; 200) geätzt wird, wobei die Maske (62; 216) als Ätzbarrier dient, und daß derart geätzt wird, daß wenigstens der ganze Weg durch den ersten Bereich (66; 220) durchdrungen wird, jedoch Schultern (72; 223) des ersten Bereichs (66; 220) intakt bleiben.

2. Verfahren nach Anspruch 1, dadurch gekennzeichnet, daß das unisotrope Ätzmittel ein Ätzmittel ist, das in eine Richtung ätzt, die von der Kristallorientierung des Halbleiterkörpers (50; 200) abhängt.

3. Verfahren nach Anspruch 1 oder 2, gekennzeichnet durch elektrisches Verbinden des ersten (66; 220) und des zweiten Bereichs (56; 218), um elektrische Kurzschlüsse (58; 230; 234; 226) zwischen ihnen auszubilden.

4. Verfahren nach Anspruch 3, dadurch gekennzeichnet, daß der Schritt des elektrischen Verbindens des ersten und des zweiten Bereichs aus dem Diffundieren eines dritten Bereichs (230) von gegensätzlichem Dotierungstyp (P) durch das Fenster (217) in den Halbleiterkörper (200) besteht, und daß der dritte Bereich (230) an den zweiten Bereich (218) angrenzt und mit dem ersten Bereich (220) einen Tunnelübergang bildet.

5. Verfahren nach einem der vorhergehenden Ansprüche, dadurch gekennzeichnet, daß der Halbleiterkörper (50; 200) aus einem Substrat (52; 92; 202; 242) mit einer epitaxialen Schicht (54; 56; 94, 96; 204; 244) darauf besteht.

6. Verfahren nach Anspruch 5, dadurch gekennzeichnet, daß das Substrat (52, 202) den Kollektor (Drain-Anschluß) eines Metalloxidhalbleiter-Feldeffekt-Transistors (MOSFET's) des einen Dotierungstyps enthält.

7. Verfahren nach Anspruch 5, dadurch gekennzeichnet, daß das Substrat einen Bereich (92; 242) eines Isolierschicht-Gleichrichters des gegensätzlichen Dotierungstyps enthält.

8. Verfahren nach einem der vorhergehenden Ansprüche, dadurch gekennzeichnet, daß die Maske (216) aus leitfähigem, feuerbeständigem Material (208) und einem Oxid (206) des Halbleiterkörpers (200) besteht, wobei das Oxid (206) das feuerbeständige material (208) von dem Körper (200) isoliert.

9. Verfahren nach einem der vorhergehenden Ansprüche, dadurch gekennzeichnet, daß das eine Dotierungsmittel ein N-Typ-Dotierungsmittel ist.

10. Verfahren nach einem der vorhergehenden Ansprüche, dadurch gekennzeichnet, daß der Halbleiterkörper (50; 200) aus Silicium besteht.

11. Halbleitervorrichtung, mit einem ersten (66; 97; 220), einem zweiten (56; 96; 218), einem dritten (54; 94; 204; 244) und einem vierten (52, 92; 202; 242) aufeinanderfolgend benachbarten Bereich, wobei der erste, zweite und dritte Bereich abwechselnde Leitfähigkeitstypen sind und der erste Bereich in den zweiten Bereich diffundiert wird; einer ersten Elektrode (76, 234), die elektrisch mit dem zweiten Bereich (56; 96; 218) verbunden ist einer zweiten Elektrode (78; 236), die elektrisch mit dem vierten Bereich (52; 92; 202, 242) verbunden ist; einer dritten Elektrode (74; 98; 208), die über Teilen des ersten, des zweiten und des dritten Bereichs liegt aber von ihnen isoliert ist und einer geätzten Nut (70; 223), die in Selbstausrichtung mit und umgeben von dem diffundierten ersten Bereich ist und die wenigstens einen Teil des zweiten Bereichs durchdringt und isolierend von der dritten Elektrode bedeckt ist, dadurch gekennzeichnet, daß der erste Bereich (66; 97; 220) eine Diffusionstiefe hat, die ungefähr gleich seiner lateralen Ausdehnung ist.

12. Halbleitervorrichtung nach Anspruch 11, dadurch gekennzeichnet, daß der erste Bereich (66; 97; 220) mit dem zweiten Bereich (56; 96; 218) elektrisch verbunden ist, so daß ein elektrischer Kurzschluß zwischen ihnen ausgebildet ist.

13. Halbleitervorrichtung nach Anspruch 11 oder 12, gekennzeichnet durch einen fünften Bereich (230) enthält, dessen Leitfähigkeitstyp (P) gegensätzlich zu dem des ersten Bereichs (220) ist, der fünfte Bereich (230) grenzt an den zweiten Bereich (218) und bildet mit dem ersten Bereich (220) einen Tunnelübergang und implementiert dadurch einen elektrischen Kurzschluß zwischen den ersten und zweiten Bereichen.

14. Halbleitervorrichtung nach einem der Ansprüche 11 bis 13, dadurch gekennzeichnet, daß der vierte Bereich (52; 92; 202; 242) aus einem Substrat besteht und der dritte Bereich (54; 94; 204; 244) aus einer epitaxialen Schicht auf dem Substrat besteht.

15. Halbleitervorrichtung nach Anspruch 14, dadurch gekennzeichnet, daß das Substrat (52; 202) den Kollektor (Drain-Anschluß) eines Metalloxidhalbleiter-Feldeffekt-Transistors (MOSFET's) desselben Leitfähigkeitstyps ($N^+$) wie dem des ersten Bereichs (66; 220) enthält.

16. Halbleitervorrichtung nach Anspruch 14, dadurch gekennzeichnet, daß das Substrat (92; 242) einen Bereich eines Isolierschicht-Gleichrichters des Leitfähigkeitstyps ($P^+$) enthält, der gegensätzlich zu dem des ersten Bereichs (97) ist.

17. Halbleitervorrichtung nach einem der Ansprüche 11 bis 16, dadurch gekennzeichnet, daß der erste Bereich (66, 97; 220) ein N-Leitfähigkeitstyp ist.

18. Halbleitervorrichtung nach einem der Ansprüche 11 bis 17, dadurch gekennzeichnet, daß der erste, zweite, dritte und vierte Bereich jeweils aus Silicium besteht.

**Revendications**

1. Procédé de fabrication d'un dispositif à semi-conducteur du type dans lequel un masque (62; 216), définissant une fenêtre (64; 217) est appliqué à une surface principale (60; 205) d'un corps à semi-conducteur (50; 200), et une première région (66; 220) d'un type de dopant ($n^+$) est formée dans une seconde région (56; 218) d'un type de dopunt opposé (P) dans le corprs (50; 200) par diffusion d'un dopant du premier type dans le corps (50; 200) par l'intermédiaire de la fenêtre (64; 217), avec le masque (62; 216) servant de barrière de diffusion, caractérisé par l'étape consistant à:

attaquer avec un agent de gravure anisotrope le corps (50; 200) par l'intermédiaire de la fenêtre (64; 217), avec le masque (62; 216) servant de barrière contre l'agent de gravure; la gravure pénétrant au moins tout le trajet traversant la première région (66; 220) mais permettant à des épaulements (72; 223) de la première région (66; 220) de rester intacts.

2. Procédé selon la revendication 1, dans lequel l'agent de gravure anisotrope comprend un agent de gravure qui procédé à une gravure dans une direction dépendant de l'orientation cristalline du corps en semi-conducteur (50; 200).

3. Procédé selon la revendication 1 ou la revendication 2, comprenant en outre l'étape consistant à connecter électriquement les premières (66; 220) et secondes (56; 218) régions pour former des court-circuits électriques (58; 230, 234, 226) entre elles.

4. Procédé selon la revendication 3, dans lequel l'étape consistant à connecter électriquement les premières et secondes régions comprend l'étape de diffusion par l'intermediate de la fenêtre (217) d'une troisième région (230) du type de dopant oppose (P) dans le corps du semiconducteur (200), cette troisième région (230) étant contiguë à la seconde région (218) et formant une jonction tunnel avec la première région (220).

5. Procédé selon l'une quelconque des revendications précédentes, dans lequel le corps du semi-conducteur (50; 200) comprend un substrat (52; 92; 202; 242) avec une couche epitaxiale (54, 56; 94, 96; 204; 244) sur son dessus.

6. Procédé selon la revendication 5, dans lequel le substrat (52, 202) comprend le drain d'un MOSFET du premier type de dopant.

7. Procédé selon la revendication 5, dans lequel le substrat comprend une région (92; 242) d'un redresseur à grille isolée du type de dopant opposée.

8. Procédé selon l'une quelconque des revendications précédentes, dans lequel le masque (216) comprend un matériau réfractaire conducteur (208) et un oxyde (206) du corps du semi-conducteur (200), l'oxyde (206) isolant le matériau réfractaire (208) du corps (200).

9. Procédé selon l'une quelconque des revendications précédentes, dans lequel le premier type de dopant est du type N.

10. Procédé selon l'une quelconque des revendications précédentes, dans lequel le corps du semi-conducteur (50; 200) comprend du silicium.

11. Dispositif à semi-conducteur ayant des première (66; 97; 200), seconde (56; 96; 218), troisième (54; 94; 204; 244) et quatrième (52, 92; 202; 242) régions successivement contigües, avec la première, la seconde et la troisième région ayant des types de conductivité alternés et la première région étant diffusée dans la seconde région; une première électrode (76, 234) connectée électriquement à la second région (56; 96; 218); une seconde électrode (78; 236) connectée électriquement à la quatrième région (52; 92; 202, 242); une troisième électrode (74, 98; 208) recouvrant, mais en en étant isolée, des parties de la première, de la seconde et la troisième région et une rainure gravée (70; 224) qui est en auto-alignement et entourée par la première région diffusée et qui pénètre au moins une partie de la seconde région et est recouverte de façon isolée par la troisième électrode; caractérisé en ce que la première région (66; 97; 220) a une profondeur de diffusion approximativement égale à son extension latérale.

12. Dispositif à semi-conducteur selon la revendication 11, dans lequel la première région (66; 97; 220) est connectée électriquement à la seconde région (56; 96; 218) de sorte qu'un court-circuit électrique se trouve formé entre elles.

13. Dispositif à semi-conducteur selon la revendication 11 ou la revendication 12, comprenant en outre une cinquième région (230), dont le type de conductivité (P) est opposé à celui de la première région (220); la cinquième région (230) étant contiguë à la seconde région (218) et formant une jonction tunnel avec la première région (220), d'ou il résulte la mise en oeuvre d'un court-circuit électrique entre les première et seconde régions.

14. Dispositif à semi-conducteur selon l'une quelconque des revendications 11 à 13, dans lequel la quatrième région (52; 92; 202, 242) comprend un substrat et la troisième région (54; 94; 204; 244) comprend une couche épitaxiale sur le substrat.

15. Dispositif à semi-conducteur selon la revendication 14, dans lequel le substrate (52, 202) comprend le drain d'un MOSFET du même type de conductivité (N⁺) que celui de la première région (66; 220).

16. Dispositf à semi-conducteur selon la revendication 14, dans lequel le substrat (92; 242) comprend une région d'un redresseur à grille isolée d'un type de conductivité opposé (P⁺) à celui de la première région (97).

17. Dispositif à semi-conducteur selon l'une quelconque des revendutions 11 à 16, dans lequel la première région (66; 97; 220) est du type de conductivité N.

18. Dispositif à semi-conducteur selon l'une des revendications 11 à 17, dans lequel les première, seconde troisième et quatrième régions comprennent chacune du silicium.

FIG. 1A
(PRIOR ART)

FIG. 1B
(PRIOR ART)

DIFFUSION
WINDOW
34

N+ DIFFUSION

32                                              32

33

N+ SOURCE          N+ SOURCE          N+ SOURCE          N+ SOURCE

22                              C        22

B

20    P BASE        A

28

18    N

30    N+   DRAIN

EP 0 091 686 B1

## FIG. 1C
(PRIOR ART)

ALIGNMENT
TOLERANCE
44

ETCH
WINDOW
40

38

33

38

N+ SOURCE

B
22

N+ SOURCE C

N+ SOURCE

22

N+ SOURCE

20    P BASE    A

42

28

18    N

30    N+   DRAIN

*FIG. 2A*

SHALLOW P+ DIFFUSION

60
58

P+                                                    P+

56. P BASE

50

54  N

52  N+  DRAIN

*FIG. 2B*

WINDOW
64

ETCH
P+ REGION

60      58      62                        62

P+                                     P+

56    P BASE

50

54    N

52    N+  DRAIN

4

FIG. 2C

WINDOW
64
N+
DIFFUSION

58   62                              62

N+    P+    E   N+   N+    P+    N+
           66  F
56  P BASE      D

50 {   54  N

52  N+  DRAIN

FIG. 2D

WINDOW
64

PREFERENTIAL
ETCH

58   62                              62

N+   P+    E  N+   N+    P+    N+
          66  F
56  P BASE  72  D   68 72

50 {   54  N          70

52  N+  DRAIN

*FIG. 2E*

GROW
OXIDE

*FIG. 2F*

SELECTIVELY
REMOVE OXIDE

FIG. 2G

FIG. 3

## FIG. 4A

DEPOSIT POLYSILICON
AND DOPE IT
208

GROW
OXIDE
210

DEPOSIT ALUMINUM
OXIDE
211

GROW
OXIDE
205    206

204    N

200

202    N+ DRAIN

## FIG. 4B

211

WINDOW
217

211

216

206  208  210

P DIFFUSION

206  208  210

216

205    219

219    205

P BASE

P BASE

P BASE

218

200

204  N

202    N+  DRAIN

*FIG. 4C*

*FIG. 4D*

*FIG. 4E*

*FIG. 4F*

*FIG. 4G*

238  208  234  208

N+   N+   230   N+   N+
P+   P BASE   220   P+  P BASE   P+   P BASE

204  N

200

202  N+ DRAIN

236

*FIG. 5*

240

N+   N+   N+   N+
P    P+   P+   P    P+   P

244  N

242  P+